# EUROPEAN PATENT APPLICATION

(11) **EP 4 671 412 A1**
(43) Date of publication of application: **31.12.2025**
(21) Application number: 25185525.0
(22) Date of filing: 26.06.2025
(51) Int. Cl.: C23C 28/04, C23C 16/02, C23C 16/36, C23C 16/40, C23C 30/00

(54) **COATED CUTTING TOOL**

(30) Priority: 28.06.2024 JP 2024105064
(71) Applicant: Tungaloy Corporation, Iwaki-shi, Fukushima 970-1144 (JP)
(72) Inventor: ISHII, Katsuya, Iwaki-shi, Fukushima, 9701144 (JP); FAN, Cangyu, Iwaki-shi, Fukushima, 970114 (JP)
(74) Representative: Vossius & Partner Patentanwälte Rechtsanwälte mbB

(57) **Abstract**

A coated cutting tool comprises a substrate and a coating layer formed on a surface of the substrate, wherein the coating layer comprises a lower layer and an upper layer formed on a surface of the lower layer, the lower layer comprises a specific Ti compound layer, an average thickness of the lower layer is 3.0 µm or more and 15.0 µm or less, the upper layer comprises an α-Al₂O₃ layer, an average thickness of the upper layer is 3.0 µm or more and 15.0 µm or less, (Σ3 + Σ11)/all grain boundaries is 15% or more in the lower layer, Σ11/(Σ3 + Σ11) is 20% or more in the region A of the lower layer, and Σ11/(Σ3 + Σ11) is 0% or more and less than 20% in the region B of the lower layer.

## Description

### Technical Field

The present invention relates to a coated cutting tool.

### Background Art

It is well known to use a coated cutting tool in which a coating layer having a total thickness of 3 µm to 20 µm is formed by a chemical vapor deposition method on the surface of a substrate composed of a cemented carbide, for cutting steel, cast iron, and the like. Known examples of the above-mentioned coating layer include a coating layer consisting of a single layer of one kind selected from the group consisting of a Ti carbide, nitride, carbonitride, oxycarbide and oxycarbonitride, and aluminum oxide, or consisting of multiple layers of two or more kinds selected from the foregoing.

Japanese Patent Laid-Open No. 2009-279693 describes a surface-coated cutting tool comprising a hard coating layer including:
(a) a lower layer including a Ti compound layer including a modified titanium carbonitride layer having an average layer thickness of at least 2 to 15 µm formed by chemical vapor deposition, and
(b) an upper layer including a modified α-aluminum oxide layer having an average layer thickness of 1 to 15 µm and having an α-crystal structure after being formed by chemical vapor deposition,
formed on a surface of a tool substrate constituted of a tungsten carbide based cemented carbide or a titanium carbonitride based cermet, wherein
when each of crystal grains having a face-centered cubic lattice present within a measurement range of a coating cross-section polished surface is individually irradiated with an electron beam using a field emission-scanning electron microscope in the lower layer (a); tilt angles of normals to (001) and (011) planes as crystal planes of the crystal grains having a NaCl-type face-centered cubic crystal structure to a normal to the cross-section polished surface are measured; based on the resulting measured tilt angles, a crossing angle of normals to (001) planes and a crossing angle of normals to (011) planes are determined at each interface between crystal grains adjacent to each other; an interface at which the crossing angle of the normals to the (001) planes and the crossing angle of the normals to the (011) planes are 2 degrees or more is defined as a grain boundary; the distribution of lattice points where each of constituent atoms shares one constituent atom between crystal grains adjacent to each other (constituent atom-shared lattice points) is then calculated at an interface between crystal grains adjacent to each other; a constituent atom-shared lattice point form in which two lattice points sharing no constituent atom are present between the constituent atom-shared lattice points is represented by Σ3; and the number and the position of lower layer Σ3 coincidence grain boundaries present facing the interface with the upper layer are measured; and
further, each of crystal grains having a hexagonal crystal lattice present within a measurement range of a coating cross-section polished surface is individually irradiated with an electron beam using a field emission-scanning electron microscope in the upper layer (b); tilt angles of normals to (0001) and (10-10) planes as crystal planes of the crystal grains having a corundom-type hexagonal close-packed crystal structure in which constituent atoms composed of Al and oxygen are present on lattice points to a normal to the cross-section polished surface are measured; based on the resulting measured tilt angles, a crossing angle of normals to (0001) planes and a crossing angle of normals to (10-10) planes are determined at each interface between crystal grains adjacent to each other; an interface at which the crossing angle of the normals to the (0001) planes and the crossing angle of the normals to the (10-10) planes are 2 degrees or more is defined as a grain boundary; the distribution of lattice points where each of constituent atoms shares one constituent atom between crystal grains adjacent to each other (constituent atom-shared lattice points) is then calculated at an interface between crystal grains adjacent to each other; a constituent atom-shared lattice point form in which two lattice points sharing no constituent atom are present between the constituent atom-shared lattice points is represented by Σ3; and the number and the position of upper layer Σ3 coincidence grain boundaries present facing the interface with the lower layer are measured,
the upper layer Σ3 coincidence grain boundaries are formed as grain boundaries continuous to the lower layer Σ3 coincidence grain boundaries in a proportion of 30 to 70% of the lower layer Σ3 coincidence grain boundaries facing the interface with the upper layer at the interface between the lower layer and the upper layer.

Japanese Patent Laid-Open No. 2009-279693 also describes a surface-coated cutting tool, wherein when each of crystal grains having a face-centered cubic lattice present within a measurement range of a coating cross-section polished surface is individually irradiated with an electron beam using a field emission-scanning electron microscope in the lower layer over a depth region of at least 1 µm from the interface between the lower layer and the upper layer to the substrate surface side; tilt angles of normals to (001) and (011) planes as crystal planes of the crystal grains having a NaCl-type face-centered cubic crystal structure to a normal to the cross-section polished surface are measured; based on the resulting measured tilt angles, a crossing angle of normals to (001) planes and a crossing angle of normals to (011) planes are determined at each interface between crystal grains adjacent to each other; an interface at which the crossing angle of the normals to the (001) planes and the crossing angle of the normals to the (011) planes are 2 degrees or more is defined as a grain boundary; the distribution of lattice points where each of constituent atoms shares one constituent atom between crystal grains adjacent to each other (constituent atom-shared lattice points) is then calculated at an interface between crystal grains adjacent to each other; a constituent atom-shared lattice point form in which N lattice points (provided that the upper limit of N is 28 in view of frequency) sharing no constituent atom are present between the constituent atom-shared lattice points is represented by ΣN + 1; and a proportion of individual ΣN + 1 in the entire ΣN + 1 is determined, a proportion of Σ3 in the entire ΣN + 1 in the region is 60% or more.

### Summary

### Technical Problem

The speed, feed and cutting depth of cutting processes have significantly increased in recent times, which, in combination with increased strength of work materials, has created a demand for further improvement in wear resistance and fracture resistance of tools compared to those involved in the prior art. In particular, in recent years, strength of cast iron has been increased to enable thickness reduction, and the number of cutting processes in which a load is exerted on a coating cutting tool, such as high-speed cutting of cast iron, has increased.

Under such a background, the surface-coated cutting tool described in Japanese Patent Laid-Open No. 2009-279693 has a high proportion of the Σ3 grain boundaries continuously formed from the titanium carbonitride layer over the α-aluminum oxide layer located at the upper part thereof and has excellent adhesion of the titanium carbonitride layer and the α-aluminum oxide layer. Meanwhile, in a coated cutting tool in which such a coating layer is formed, cracks occurred during machining are easily propagated to the substrate, chipping and fractures due to this occur, and thus there is room for improvement.

The present invention has been made in light of the above circumstances, and an object of the present invention is to provide a coated cutting tool which has excellent wear resistance and fracture resistance and which accordingly allows for an extended tool life.

### Solution to Problem

The inventors of the present invention have conducted research on extending the tool life of a coated cutting tool from the above perspective. It has been found that, when a coated cutting tool has a specific configuration, wear resistance and fracture resistance are excellent, and as a result, the tool life can be extended. The present invention has been accomplished based on this finding.

That is, the present invention is as follows.
[1] A coated cutting tool comprising a substrate and a coating layer formed on a surface of the substrate, wherein
   the coating layer comprises a lower layer and an upper layer formed on a surface of the lower layer,
   the lower layer comprises a Ti compound layer containing a Ti compound of Ti and at least two elements selected from the group consisting of C, N, O and B,
   an average thickness of the lower layer is 3.0 µm or more and 15.0 µm or less,
   the upper layer comprises an α-Al₂O₃ layer containing α-aluminum oxide,
   an average thickness of the upper layer is 3.0 µm or more and 15.0 µm or less,
   a proportion of a sum of a length of a Σ3 grain boundary and a length of a Σ11 grain boundary to a total length of all grain boundaries of 100% is 15% or more in the entire lower layer, and
   when a range of 2 µm from an interface between the lower layer and the upper layer to the substrate side is taken as a region A and a range on the substrate side of the region A is taken as a region B, a proportion of the length of the Σ11 grain boundary to the sum of the length of the Σ3 grain boundary and the length of the Σ11 grain boundary is 20% or more in the region A of the lower layer, and the proportion of the length of the Σ11 grain boundary to the sum of the length of the Σ3 grain boundary and the length of the Σ11 grain boundary is 0% or more and less than 20% in the region B of the lower layer.
[2] The coated cutting tool according to [1], wherein the proportion of the sum of the length of the Σ3 grain boundary and the length of the Σ11 grain boundary to the total length of all grain boundaries of 100% is 10% or more and 60% or less in the region A of the lower layer.
[3] The coated cutting tool according to [1] or [2], wherein the proportion of the sum of the length of the Σ3 grain boundary and the length of the Σ11 grain boundary to the total length of all grain boundaries of 100% is 20% or more and 70% or less in the region B of the lower layer.
[4] The coated cutting tool according to any one of [1] to [3], wherein the coating layer comprises an adhesion layer between the lower layer and the substrate,
   the adhesion layer comprises a Ti nitride layer and/or a Ti carbide layer, and
   an average thickness of the adhesion layer is 0.1 µm or more and 3.0 µm or less.
[5] The coated cutting tool according to any one of [1] to [4], wherein the coating layer further comprises an outer layer on a surface of the upper layer opposite to the substrate,
   the outer layer comprises a compound of Ti and at least one element selected from the group consisting of C, N, O and B, and
   an average thickness of the outer layer is 0.1 µm or more and 4.0 µm or less.
[6] The coated cutting tool according to any one of [1] to [5], wherein an average thickness of the entire coating layer is 10.0 µm or more and 30.0 µm or less.
[7] The coated cutting tool according to any one of [1] to [6], wherein the substrate is composed of any of a cemented carbide, a cermet, a ceramic and a cubic boron nitride sintered body.

### Advantageous Effects of Invention

According to the present invention, it is possible to provide a coated cutting tool that has excellent wear resistance and fracture resistance, thereby making it possible to extend the tool life.

### Brief Description of Drawings

FIG. 1 is a schematic cross-sectional view showing an example of a coated cutting tool according to the present invention; and
FIG. 2 is a schematic cross-sectional view showing another example of a coated cutting tool according to the present invention.

### Description of Embodiments

Hereinafter, a mode for carrying out the present invention (hereinafter, simply referred to as "the present embodiment") will be described in detail with reference to the drawings as necessary, but the present invention is not limited to the present embodiment described below. The present invention can be variously modified without departing from the gist thereof. In addition, in the drawings, positional relationships such as up, down, left, and right are based on the positional relationships shown in the drawings unless otherwise specified. Further, the dimensional ratios of the drawings are not limited to those shown therein.

A coated cutting tool of the present embodiment comprises a substrate and a coating layer formed on a surface of the substrate, wherein the coating layer comprises a lower layer and an upper layer formed on a surface of the lower layer, the lower layer comprises a Ti compound layer containing a Ti compound of Ti and at least two elements selected from the group consisting of C, N, O and B, an average thickness of the lower layer is 3.0 µm or more and 15.0 µm or less, the upper layer comprises an α-Al₂O₃ layer containing α-aluminum oxide, an average thickness of the upper layer is 3.0 µm or more and 15.0 µm or less, a proportion of a sum of a length of a Σ3 grain boundary and a length of a Σ11 grain boundary to a total length of all grain boundaries of 100% is 15% or more in the entire lower layer, and when a range of 2 µm from an interface between the lower layer and the upper layer to the substrate side is taken as a region A (hereinafter also simply referred to as "the region A") and a range on the substrate side of the region A is taken as a region B (hereinafter also simply referred to as "the region B"), a proportion of the length of the Σ11 grain boundary to the sum of the length of the Σ3 grain boundary and the length of the Σ11 grain boundary is 20% or more in the region A of the lower layer, and the proportion of the length of the Σ11 grain boundary to the sum of the length of the Σ3 grain boundary and the length of the Σ11 grain boundary is 0% or more and less than 20% in the region B of the lower layer.

The coated cutting tool of the present embodiment comprising the above-described configurations has excellent wear resistance and fracture resistance, and can thus extend the tool life thereof. The factors that improve the wear resistance and fracture resistance of the coated cutting tool of the present embodiment are considered hereinbelow. However, the considered factors are not limiting. First, in the coated cutting tool of the present embodiment, where the average thickness of the lower layer is 3.0 µm or more, wear resistance is excellent. Meanwhile, where the average thickness of the lower layer is 15.0 µm or less, the adhesion of the coating layer is improved to improve the chipping resistance, so that fracture resistance is excellent. In the coated cutting tool of the present embodiment, where the average thickness of the upper layer is 3.0 µm or more, wear resistance is excellent. Meanwhile, where the average thickness of the upper layer is 15.0 µm or less, the adhesion of the coating layer is improved to improve the chipping resistance, so that fracture resistance is excellent. In the coated cutting tool of the present embodiment, where the proportion of the sum of the length of the Σ3 grain boundary and the length of the Σ11 grain boundary to the total length of all grain boundaries of 100% is 15% or more in the entire lower layer, the proportion of the grain boundary having low grain boundary energy is increased and plastic deformation resistance is improved, so that wear resistance is excellent. In the coated cutting tool of the present embodiment, where the proportion of the length of the Σ11 grain boundary to the sum of the length of the Σ3 grain boundary and the length of the Σ11 grain boundary is 20% or more in the region A of the lower layer, the adhesion with the upper layer is improved, so that high wear resistance and fracture resistance are exhibited over a long period. In the coated cutting tool of the present embodiment, where the proportion of the length of the Σ11 grain boundary to the sum of the length of the Σ3 grain boundary and the length of the Σ11 grain boundary is 0% or more and less than 20% in the region B of the lower layer, the proportion of the grain boundary having low grain boundary energy is increased and plastic deformation resistance is improved, so that wear resistance is excellent. In the coated cutting tool of the present embodiment, where the proportion of the length of the Σ11 grain boundary to the sum of the length of the Σ3 grain boundary and the length of the Σ11 grain boundary is controlled so as to satisfy the above-described range in each of the regions A and B, an effect of suppressing the propagation of cracks to the substrate occurred during cutting can be effectively and reliably exhibited. Due to a combination of these effects, the coated cutting tool of the present embodiment has excellent wear resistance and fracture resistance and the tool life can be extended.

In the present embodiment, the "Σn grain boundary" can also be expressed as "Σn" or the "Σn-grain boundary".

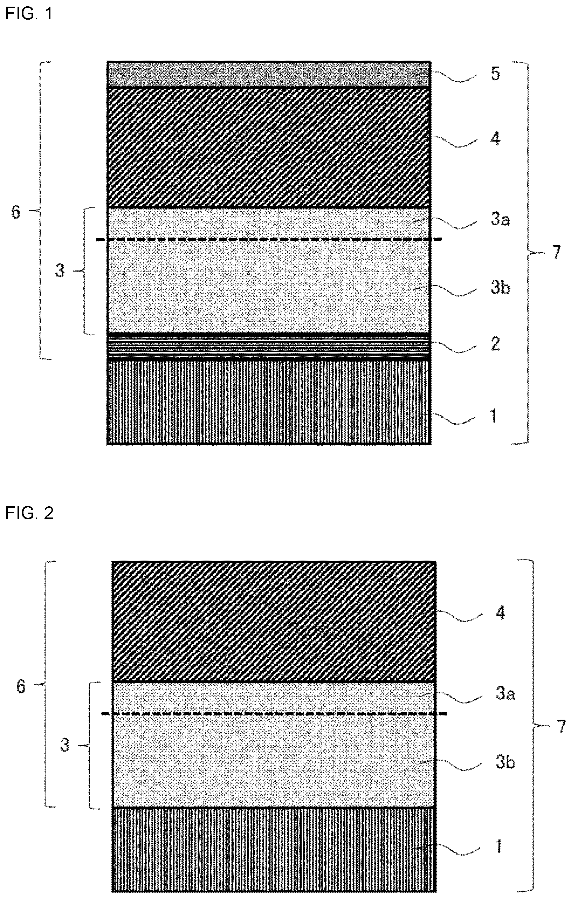

FIG. 1 is a schematic sectional view showing an example of the coated cutting tool of the present embodiment. A coated cutting tool 7 comprises a substrate 1 and a coating layer 6 formed on the surface of the substrate 1. In the coating layer 6, an adhesion layer 2, a lower layer 3, an upper layer 4, and an outer layer 5 are layered in an upward direction in this order from the substrate 1 side. In the lower layer 3, a range of 2 µm from an interface between the lower layer 3 and the upper layer 4 to a substrate 1 side is taken as a region A 3a and a range from an interface of the region A 3a to the substrate 1 is taken as a region B 3b.

FIG. 2 is a schematic cross-sectional view showing another example of the coated cutting tool of the present embodiment. A coated cutting tool 7 comprises a substrate 1 and a coating layer 6 formed on the surface of the substrate 1. In the coating layer 6, a lower layer 3 and an upper layer 4 are layered in this order in an upward direction from the substrate 1 side. In the lower layer 3, a range of 2 µm from an interface between the lower layer 3 and the upper layer 4 to a substrate 1 side is taken as a region A 3a and a range from an interface of the region A 3a to the substrate 1 is taken as a region B 3b.

The coated cutting tool of the present embodiment comprises a substrate and a coating layer formed on the surface of the substrate. Specific examples of the type of coated cutting tool include a cutting edge exchangeable cutting insert for milling or turning, a drill and an end mill.

The substrate in the present embodiment is not particularly limited as long as it can be used as the substrate of the coated cutting tool. Examples of such a substrate include cemented carbides, cermets, ceramics, cubic boron nitride sintered bodies, diamond sintered bodies, and high-speed steels. From among the above examples, the substrate is preferably comprised of a cemented carbide, cermet, ceramic or a cubic boron nitride sintered body as this provides further excellent wear resistance and fracture resistance, and, from the same perspective, the substrate is more preferably comprised of a cemented carbide.

The surface of the substrate may be modified. For example, when the substrate is made of a cemented carbide, a β free layer may be formed on the surface thereof. Further, where the substrate is made of a cermet, a hardened layer may be formed on the surface thereof. The effects of the present invention can be obtained even if the surface of the substrate is modified as described above.

The average thickness of the entire coating layer in the present embodiment is preferably 10.0 µm or more and 30.0 µm or less. In the coated cutting tool of the present embodiment, where the average thickness of the entire coating layer is 10.0 µm or more, wear resistance tends to be excellent, and where the average thickness of the entire coating layer is 30.0 µm or less, the adhesion of the coating layer is improved to improve the chipping resistance, so that fracture resistance tends to be excellent. From the same viewpoint, the average thickness of the entire coating layer is more preferably 10.6 µm or more and 29.4 µm or less, and even more preferably 12.7 µm or more and 26.2 µm or less.

The average thickness of each layer and the entire coating layer in the coated cutting tool of the present embodiment can be determined by measuring the thickness of each layer or the thickness of the entire coating layer from the cross-section at three or more places in each layer or the entire coating layer and calculating the arithmetic mean value.

### Lower Layer

The lower layer used in the present embodiment includes a Ti compound layer containing a Ti compound of Ti and at least two elements selected from the group consisting of C, N, O and B.

The Ti compound layer is not particularly limited, and examples thereof include a TiCN layer containing TiCN, a TiCO layer containing TiCO, a TiCNO layer containing TiCNO, and a TiON layer containing TiON.

The lower layer may be constituted of one layer or may be constituted of multiple layers (for example, two layers or three layers), but is preferably constituted of multiple layers, more preferably of two or three layers, and even more preferably of two layers. When the lower layer is constituted of two layers, the lower layer may comprise a TiCN layer as a first layer on the substrate side and a TiCNO layer or a TiCO layer as a second layer on the surface of the first layer. Among these configurations, the lower layer may comprise a TiCN layer as the first layer on the substrate side and a TiCNO layer as the second layer on the surface of the first layer.

The average thickness of the lower layer used in the present embodiment is 3.0 µm or more and 15.0 µm or less. In the coated cutting tool of the present embodiment, where the average thickness of the lower layer is 3.0 µm or more, wear resistance is excellent. Meanwhile, where the average thickness of the lower layer is 15.0 µm or less, the adhesion of the coating layer is improved to improve the chipping resistance, so that fracture resistance is excellent. From the same viewpoint, the average thickness of the lower layer is more preferably 4.0 µm or more and 14.5 µm or less, even more preferably 4.5 µm or more and 14.0 µm or less, and still more preferably 6.0 µm or more and 13.0 µm or less.

When the lower layer is constituted of two layers, the average thickness of the first layer (TiCN layer) is preferably 2.0 µm or more and 14.5 µm or less from the viewpoint of further improving wear resistance and fracture resistance. From the same viewpoint, the average thickness of the first layer (TiCN layer) is more preferably 3.0 µm or more and 14.0 µm or less, and even more preferably 4.5 µm or more and 13.5 µm or less.

When the lower layer is constituted of two layers, the average thickness of the second layer (TiCNO layer or TiCO layer) is preferably 0.1 µm or more and 2.0 µm or less from the viewpoint of further improving wear resistance and fracture resistance. From the same viewpoint, the average thickness of the second layer (TiCNO layer or TiCO layer) is more preferably 0.2 µm or more and 2.0 µm or less, and even more preferably 0.5 µm or more and 2.0 µm or less.

The Ti compound layer of the lower layer is constituted of one or more layers described above, but may include a trace amount of a component other than the above elements as long as the effects of the present invention are exhibited.

In the coated cutting tool of the present embodiment, the proportion of the sum of the length of the Σ3 grain boundary and the length of the Σ11 grain boundary to the total length of all grain boundaries of 100% is 15% or more in the entire lower layer. In the coated cutting tool of the present embodiment, where the proportion of the sum of the length of the Σ3 grain boundary and the length of the Σ11 grain boundary to the total length of all grain boundaries of 100% is 15% or more in the entire lower layer, the proportion of the grain boundary having low grain boundary energy is increased and plastic deformation resistance is improved, so that wear resistance is excellent. Meanwhile, from the viewpoint of ease of production, the proportion of the sum of the length of the Σ3 grain boundary and the length of the Σ11 grain boundary to the total length of all grain boundaries of 100% is preferably 70% or less in the entire lower layer. From the same viewpoint, the proportion of the sum of the length of the Σ3 grain boundary and the length of the Σ11 grain boundary to the total length of all grain boundaries of 100% is more preferably 17% or more and 66% or less, and even more preferably 23% or more and 59% or less in the entire lower layer.

In the coated cutting tool of the present embodiment, the proportion of the length of the Σ11 grain boundary to the sum of the length of the Σ3 grain boundary and the length of the Σ11 grain boundary is 20% or more in the region A of the lower layer. In the coated cutting tool of the present embodiment, where the proportion of the length of the Σ11 grain boundary to the sum of the length of the Σ3 grain boundary and the length of the Σ11 grain boundary is 20% or more in the region A of the lower layer, the adhesion with the upper layer is improved, so that high wear resistance and high fracture resistance are exhibited over a long period. Meanwhile, from the viewpoint of ease of production, the proportion of the length of the Σ11 grain boundary to the sum of the length of the Σ3 grain boundary and the length of the Σ11 grain boundary is preferably 60% or less in the region A of the lower layer. From the same viewpoint, the proportion of the length of the Σ11 grain boundary to the sum of the length of the Σ3 grain boundary and the length of the Σ11 grain boundary is more preferably 22% or more and 59% or less, and even more preferably 28% or more and 53% or less in the region A of the lower layer.

In the coated cutting tool of the present embodiment, the proportion of the length of the Σ11 grain boundary to the sum of the length of the Σ3 grain boundary and the length of the Σ11 grain boundary is 0% or more and less than 20% in the region B of the lower layer. In the coated cutting tool of the present embodiment, where the proportion of the length of the Σ11 grain boundary to the sum of the length of the Σ3 grain boundary and the length of the Σ11 grain boundary is 0% or more and less than 20% in the region B of the lower layer, the proportion of the grain boundary having low grain boundary energy is increased and plastic deformation resistance is improved, so that wear resistance is excellent. From the same viewpoint, the proportion of the length of the Σ11 grain boundary to the sum of the length of the Σ3 grain boundary and the length of the Σ11 grain boundary is preferably 0% or more and 19% or less, more preferably 0% or more and 17% or less, and even more preferably 0% or more and 12% or less in the region B of the lower layer.

In the coated cutting tool of the present embodiment, where the proportion of the length of the Σ11 grain boundary to the sum of the length of the Σ3 grain boundary and the length of the Σ11 grain boundary is controlled so as to satisfy the above-described range in each of the regions A and B, the effect of suppressing the propagation of cracks to the substrate occurred during cutting can be effectively and reliably exhibited.

In the coated cutting tool of the present embodiment, the proportion of the sum of the length of the Σ3 grain boundary and the length of the Σ11 grain boundary to the total length of all grain boundaries of 100% is preferably 10% or more and 60% or less in the region A of the lower layer. In the coated cutting tool of the present embodiment, where the proportion of the sum of the length of the Σ3 grain boundary and the length of the Σ11 grain boundary to the total length of all grain boundaries of 100% is 10% or more in the region A of the lower layer, the effect of improving wear resistance and fracture resistance obtained by increasing the proportion of the length of the Σ11 grain boundary to the sum of the length of the Σ3 grain boundary and the length of the Σ11 grain boundary in the region A described above tends to be effectively and reliably exhibited. Meanwhile, in the coated cutting tool of the present embodiment, where the proportion of the sum of the length of the Σ3 grain boundary and the length of the Σ11 grain boundary to the total length of all grain boundaries of 100% is 60% or less in the region A of the lower layer, coarsening of grains is suppressed, so that chipping resistance tends to be improved and fracture resistance tends to be further excellent. From the same viewpoint, the proportion of the sum of the length of the Σ3 grain boundary and the length of the Σ11 grain boundary to the total length of all grain boundaries of 100% is more preferably 12% or more and 57% or less, even more preferably 15% or more and 54% or less, and still more preferably 20% or more and 48% or less in the region A of the lower layer.

In the coated cutting tool of the present embodiment, the proportion of the sum of the length of the Σ3 grain boundary and the length of the Σ11 grain boundary to the total length of all grain boundaries of 100% is preferably 20% or more and 70% or less in the region B of the lower layer. In the coated cutting tool of the present embodiment, where the proportion of the sum of the length of the Σ3 grain boundary and the length of the Σ11 grain boundary to the total length of all grain boundaries of 100% is 20% or more in the region B of the lower layer, plastic deformation resistance is improved, so that wear resistance tends to be further excellent. Meanwhile, in the coated cutting tool of the present embodiment, where the proportion of the sum of the length of the Σ3 grain boundary and the length of the Σ11 grain boundary to the total length of all grain boundaries of 100% is 70% or less in the region B of the lower layer, the above-described proportion of the sum of the length of the Σ3 grain boundary and the length of the Σ11 grain boundary to the total length of all grain boundaries of 100% in the region A tends to be easily controlled so as to be 60% or less. From the same viewpoint, the proportion of the sum of the length of the Σ3 grain boundary and the length of the Σ11 grain boundary to the total length of all grain boundaries of 100% is more preferably 22% or more and 68% or less, and even more preferably 24% or more and 61% or less in the region B of the lower layer.

In the present application, the length of CSL grain boundaries means, among coincidence grain boundaries represented by a combination of Σ and a number, "the total length of Σ3 grain boundaries, Σ5 grain boundaries, Σ7 grain boundaries, Σ9 grain boundaries, Σ11 grain boundaries, Σ13 grain boundaries, Σ15 grain boundaries, Σ17 grain boundaries, Σ19 grain boundaries, Σ21 grain boundaries, Σ23 grain boundaries, Σ25 grain boundaries, Σ27 grain boundaries, and Σ29 grain boundaries".

The lower layer in the present embodiment has grain boundaries having relatively high grain boundary energy and grain boundaries having relatively low grain boundary energy. Usually, since the arrangement of atoms is irregular and disorder and atoms are randomly arranged, grain boundaries have many gaps and relatively high grain boundary energy. Meanwhile, some grain boundaries have regular arrangement of atoms and few gaps, and such grain boundaries have relatively low grain boundary energy. Representative examples of such grain boundaries having relatively low grain boundary energy include a coincidence site lattice grain boundary (hereinafter, also referred to as "the CSL grain boundary"). Grain boundaries give a significant effect on important sintering processes such as densification, creep, and diffusion, as well as on electrical, optical, and mechanical characteristics. The importance of grain boundaries depends on several factors such as a grain boundary density in a material, a chemical composition at an interface, and a crystallographic texture, specifically, a grain boundary plane orientation and a crystal grain misorientation. The CSL grain boundary plays a special role. A Σ value is known as an index indicating the degree of the distribution of the CSL grain boundary, and is defined as a ratio of a crystal lattice point density of two crystal grains that are in contact with each other at a grain boundary to a density of matching lattice points when both crystal lattices are superposed. In the case of a simple structure, it is generally recognized that a grain boundary having a low Σ value tends to have low interface energy and special characteristics. Thus, controlling the proportion of the CSL grain boundary and the distribution of the crystal grain misorientation is considered to be important for the characteristics of the lower layer and the improvement thereof.

In recent years, a technology based on a scanning electron microscope (hereinafter, also referred to as "SEM") known as electron backscatter diffraction (hereinafter, also referred to as "EBSD") is used to study grain boundaries in a material. EBSD is based on automatic analysis of Kikuchi diffraction patterns generated by backscattered electrons.

For each crystal grain of a target material, a crystallographic orientation is determined after preparing a corresponding diffraction pattern index. When EBSD is used together with commercially available software, texture analysis and determination of grain boundary character distribution (GBCD) are relatively easily carried out. When the interface is measured and analyzed by EBSD, the misorientation of the grain boundary in a sample group having a large interface can be clarified. Usually, the distribution of the misorientation is related to the treatment and/or physical properties of the material. The misorientation of the grain boundary is obtained from usual orientation parameters such as an Euler angle, an angle/axis pair, or a Rodrigues vector.

The CSL grain boundary of the lower layer usually includes Σ3 grain boundaries, Σ5 grain boundaries, Σ7 grain boundaries, Σ9 grain boundaries, Σ11 grain boundaries, Σ13 grain boundaries, Σ15 grain boundaries, Σ17 grain boundaries, Σ19 grain boundaries, Σ21 grain boundaries, Σ23 grain boundaries, Σ25 grain boundaries, Σ27 grain boundaries, and Σ29 grain boundaries. Here, for example, the length of the Σ3 grain boundary represents the total length of the Σ3 grain boundaries in a field of view (specific region) observed by an SEM equipped with EBSD.

Here, all grain boundaries are the sum of grain boundaries other than the CSL grain boundary and the CSL grain boundary. Hereinafter, grain boundaries other than the CSL grain boundary are referred to as "the general grain boundary" or "the random grain boundary". The general grain boundary refers to remaining grain boundaries excluding the CSL grain boundary from all grain boundaries of the crystal grains in the lower layer observed with an SEM equipped with EBSD. Therefore, "the total length of all grain boundaries" can be represented by "the sum of the length of the CSL grain boundary and the length of the general grain boundary".

In the present embodiment, the proportion of the sum of the length of the Σ3 grain boundary and the length of the Σ11 grain boundary to the total length of all grain boundaries of 100% in the entire lower layer, the proportion of the length of the Σ11 grain boundary to the sum of the length of the Σ3 grain boundary and the length of the Σ11 grain boundary in the regions A and B of the lower layer, and the proportion of the sum of the length of the Σ3 grain boundary and the length of the Σ11 grain boundary to the total length of all grain boundaries of 100% in the regions A and B of the lower layer can be calculated as follows.

A cross-section of the lower layer of the coated cutting tool is exposed in a direction perpendicular to the surface of the substrate to obtain an observation surface. Examples of the method for exposing the cross-section of the lower layer include cutting and polishing. Of these, polishing is preferable from the viewpoint of making the observation surface of the lower layer smoother. In particular, the observation surface is preferably a mirror surface from the viewpoint of being smoother. The method for obtaining a mirror observation surface of the lower layer is not particularly limited, and examples thereof include polishing using diamond paste or colloidal silica, and ion milling.

Thereafter, the above observation surface is observed with an SEM equipped with EBSD. As the observation region, a rake face is preferably observed.

As the SEM, SU6600 (manufactured by Hitachi High-Technologies Corporation) equipped with EBSD (manufactured by TexSEM Laboratories, Inc.) is used.

The normal to the observation surface is tilted by 70° with respect to an incident beam, and the analysis is carried out by irradiating the observation surface with an electron beam at an accelerating voltage of 15 kV and an irradiation current of 1.0 nA. Data collection is carried out by setting EBSD at a step size (distance between measurement points) of 0.1 µm in a measurement range including 50 µm in a direction parallel to the substrate surface and the entire lower layer in a direction perpendicular to the substrate surface on the observation surface and analyzing the crystal orientation of each grain in the lower layer in the measurement range. At this time, the boundary between measurement points having a misorientation of 5 degrees or more is taken as the grain boundary.

Data processing is carried out by using commercially available software. The CSL grain boundaries corresponding to any arbitrary Σ value are counted and can be confirmed by being expressed as the ratio to all grain boundaries. As described above, the length of the Σn grain boundary (n is an odd number of 3 or more and 29 or less), the length of the CSL grain boundary, and the total length of all grain boundaries in the lower layer are determined. The analysis is performed at three fields of view in total in the above-described measurement range on the observation surface, and the average value of respective numerical values is determined. The proportion of the sum of the length of the Σ3 grain boundary and the length of the Σ11 grain boundary to the total length of all grain boundaries of 100% in the entire lower layer, the proportion of the length of the Σ11 grain boundary to the length of the Σ3 grain boundary and the length of the Σ11 grain boundary in the regions A and B of the lower layer, and the proportion of the sum of the length of the Σ3 grain boundary and the length of the Σ11 grain boundary to the total length of all grain boundaries of 100% in the regions A and B of the lower layer can be calculated from the obtained average values.

### Upper Layer

In the coated cutting tool of the present embodiment, the coating layer comprises a lower layer and an upper layer formed on the surface of the lower layer. The upper layer used in the present embodiment comprises an α-Al₂O₃ layer containing α-aluminum oxide. Since the coated cutting tool of the present embodiment comprises the upper layer made of an α-Al₂O₃ layer containing α-aluminum oxide, it is possible to suppress the reactive wear due to the oxidation of the Ti compound layer as the lower layer. As a result, the coated cutting tool of the present embodiment has improved wear resistance.

The average thickness of the upper layer used in the present embodiment is 3.0 µm or more and 15.0 µm or less. In the coated cutting tool of the present embodiment, where the average thickness of the upper layer is 3.0 µm or more, wear resistance is excellent. Meanwhile, where the average thickness of the upper layer is 15.0 µm or less, the adhesion of the coating layer is improved to improve the chipping resistance, so that fracture resistance is excellent. From the same viewpoint, the average thickness of the upper layer is preferably 3.6 µm or more and 14.8 µm or less, and more preferably 4.2 µm or more and 14.5 µm or less.

The α-Al₂O₃ layer of the upper layer is constituted of an α-aluminum oxide layer, but may include a trace amount of components other than α-aluminum oxide (α-Al₂O₃) as long as the effects of the present invention are exhibited.

### Adhesion Layer

In the coated cutting tool of the present embodiment, the coating layer preferably comprises an adhesion layer between the lower layer and the substrate. The adhesion layer comprises a Ti nitride layer (TiN layer) and/or a Ti carbide layer (TiC layer).

Further, the average thickness of the adhesion layer is preferably 0.1 µm or more and 3.0 µm or less. In the coated cutting tool of the present embodiment, where the average thickness of the adhesion layer is 0.1 µm or more, the Ti nitride layer and/or the Ti carbide layer tend(s) to have a uniform texture, the adhesion of the coating layer is further improved, and the chipping resistance is improved, so that the fracture resistance tends to be excellent. Meanwhile, in the coated cutting tool of the present embodiment, where the average thickness of the adhesion layer is 3.0 µm or less, the adhesion of the coating layer is improved and the chipping resistance is improved, so that the fracture resistance tends to be excellent. From the same viewpoint, the average thickness of the adhesion layer is more preferably 0.1 µm or more and 2.5 µm or less, and even more preferably 0.2 µm or more and 1.5 µm or less.

The adhesion layer comprises a Ti nitride layer and/or a Ti carbide layer. However, as long as the effects of the present invention are exhibited, the adhesion layer may include a trace amount of components other than Ti nitride and/or Ti carbide.

### Outer Layer

In the coated cutting tool of the present embodiment, the coating layer preferably further comprises an outer layer on a surface of the upper layer opposite to the substrate. The outer layer comprises a compound of Ti and at least one element selected from the group consisting of C, N, O and B. The outer layer is not particularly limited, and specific examples thereof include a TiC layer containing TiC, a TiN layer containing TiN, a TiCN layer containing TiCN, a TiCO layer containing TiCO, a TiCNO layer containing TiCNO, a TiON layer containing TiON, and a TiB₂ layer containing TiB₂. Among these, a TiN layer and a TiCN layer are preferable.

Further, the average thickness of the outer layer is preferably 0.1 µm or more and 4.0 µm or less. In the coated cutting tool of the present embodiment, since the average thickness of the outer layer is 0.1 µm or more, the wear resistance tends to be excellent. In addition, the corner used tends to be easily identified. Meanwhile, in the coated cutting tool of the present embodiment, where the average thickness of the outer layer is 4.0 µm or less, the adhesion of the coating layer is improved and the chipping resistance is improved, so that the fracture resistance tends to be excellent. From the same viewpoint, the average thickness of the outer layer is more preferably 0.2 µm or more and 2.0 µm or less, and even more preferably 0.2 µm or more and 1.5 µm or less.

The outer layer is constituted of a compound of Ti and at least one element selected from the group consisting of C, N, O and B. However, such Ti compound layer may contain a trace amount of components other than the compound of Ti and at least one element selected from the group consisting of C, N, O and B, as long as the effects of the present invention are exhibited.

For example, the following method can be used for forming each layer constituting the coating layer in the coated cutting tool of the present embodiment. However, this method of forming each layer is not limiting.

First, an adhesion layer composed of a Ti nitride layer (TiN layer) and/or a Ti carbide layer (TiC layer) is formed on the surface of the substrate. The adhesion layer is formed, for example, by the following method.

The TiN layer is formed by a chemical vapor deposition method in which the raw material composition is TiCl₄: 5.0 to 10.0 mol%, N₂: 20 to 60 mol%, H₂: balance, the temperature is 850 to 950°C, and the pressure is 300 to 400 hPa.

The TiC layer is formed by a chemical vapor deposition method in which the raw material composition is TiCl₄: 1.0 to 4.0 mol%, CH₄: 3.0 to 6.0 mol%, H₂: balance, the temperature is 950 to 1050°C, and the pressure is 70 to 80 hPa.

Next, a lower layer made of a Ti compound layer is formed on the surface of the adhesion layer. In the case where no adhesion layer is formed, a lower layer made of a Ti compound layer is formed on the surface of the substrate. The lower layer is formed, for example, by a method in which the following step (1), annealing step, step (2), and step (3) are carried out in this order.

### Step 1: Formation step of lower layer-first layer (lower layer side-region B)

When a TiCN layer is formed as the first layer (lower layer side-region B) of the lower layer, a part of or the whole first layer is formed by a chemical vapor deposition method in which the raw material composition is TiCl₄: 6.0 to 8.0 mol%, CH₃CN: 0.8 to 1.2 mol%, N₂: 10.0 to 35.0 mol%, C₂H₄: 0 to 0.5 mol%, H₂: balance, the temperature is 820 to 880°C, and the pressure is 55 to 110 hPa. When the whole first layer is formed in the step 1, the step 2 described below may not be conducted.

### Annealing Step

Next, the annealing step in which the raw material composition is C₂H₄: 0.5 to 1.5 mol%, N₂: 40.0 to 50.0 mol%, H₂: balance, the temperature is 950 to 1050°C, and the pressure is 110 to 130 hPa is conducted. The time of the annealing step is preferably 15 to 45 min.

### Step 2: Formation step of lower layer-first layer (upper layer side-region A)

When a TiCN layer is formed as the first layer (upper layer side-region A) of the lower layer, all the remaining part of the first layer is formed by a chemical vapor deposition method in which the raw material composition is TiCl₄: 9.0 to 11.0 mol%, CH₃CN: 0.4 to 0.8 mol%, N₂: 10.0 to 30.0 mol%, H₂: balance, the temperature is 980 to 1020°C, and the pressure is 100 to 140 hPa.

### Step 3: Formation step of lower layer-second layer (region A)

When a TiCNO layer is formed as the second layer (region A) of the lower layer, the second layer is formed by a chemical vapor deposition method in which the raw material composition is TiCl₄: 9.0 to 11.0 mol%, CH₃CN: 0.4 to 0.8 mol%, CO: 1.0 to 2.0 mol%, N₂: 10.0 to 30.0 mol%, H₂: balance, the temperature is 980 to 1020°C, and the pressure is 100 to 140 hPa.

When a TiCO layer is formed as the second layer (region A) of the lower layer, the second layer is formed by a chemical vapor deposition method in which the raw material composition is TiCl₄: 5.0 to 7.0 mol%, CO: 2.0 to 3.0 mol%, H₂: balance, the temperature is 980 to 1020°C, and the pressure is 80 to 120 hPa.

When the lower layer is made of only one layer, the step 3 may not be conducted.

In the above step 1 (formation step of region B), for example, the proportion of the length of the Σ11 grain boundary to the sum of the length of the Σ3 grain boundary and the length of the Σ11 grain boundary in the region B of the lower layer can be controlled by adjusting the pressure and the amount of C₂H₄ in the raw material. Specifically, for example, when the pressure in the step 1 is reduced, the proportion of the length of the Σ11 grain boundary to the sum of the length of the Σ3 grain boundary and the length of the Σ11 grain boundary in the region B of the lower layer can be reduced. In addition, for example, when the amount of C₂H₄ in the raw material in the step 1 is increased, the proportion of the length of the Σ11 grain boundary to the sum of the length of the Σ3 grain boundary and the length of the Σ11 grain boundary in the region B of the lower layer can be increased.

In the above step 1 (formation step of region B), for example, the proportion of the sum of the length of the Σ3 grain boundary and the length of the Σ11 grain boundary to the total length of all grain boundaries of 100% in the region B of the lower layer can be controlled by adjusting the pressure and the amount of N₂ in the raw material. Specifically, for example, when the pressure in the step 1 is reduced, the proportion of the sum of the length of the Σ3 grain boundary and the length of the Σ11 grain boundary to the total length of all grain boundaries of 100% in the region B of the lower layer can be increased. In addition, for example, when the amount of N₂ in the raw material in the step 1 is increased, the proportion of the sum of the length of the Σ3 grain boundary and the length of the Σ11 grain boundary to the total length of all grain boundaries of 100% in the region B of the lower layer can be increased.

For example, the proportion of the length of the Σ11 grain boundary to the sum of the length of the Σ3 grain boundary and the length of the Σ11 grain boundary in the region A of the lower layer can be controlled by adjusting the presence or absence of the annealing step as well as each condition in the above steps 2 and 3 (formation step of region A). Specifically, for example, when the annealing step is conducted, the proportion of the length of the Σ11 grain boundary to the sum of the length of the Σ3 grain boundary and the length of the Σ11 grain boundary in the region A of the lower layer can be increased. For example, when the annealing step is conducted and the amount of TiCl₄ in the raw material in the steps 2 and 3 (formation step of region A) is increased, the proportion of the length of the Σ11 grain boundary to the sum of the length of the Σ3 grain boundary and the length of the Σ11 grain boundary in the region A of the lower layer can be increased. For example, when the annealing step is not conducted and the amount of TiCl₄ in the raw material in the steps 2 and 3 (formation step of region A) is increased, the proportion of the length of the Σ11 grain boundary to the sum of the length of the Σ3 grain boundary and the length of the Σ11 grain boundary in the region A of the lower layer tends to be reduced. For example, also when the proportion of the length of the Σ11 grain boundary to the sum of the length of the Σ3 grain boundary and the length of the Σ11 grain boundary in the region B of the lower layer is reduced, the proportion of the length of the Σ11 grain boundary to the sum of the length of the Σ3 grain boundary and the length of the Σ11 grain boundary in the region A of the lower layer can be reduced.

For example, the proportion of the sum of the length of the Σ3 grain boundary and the length of the Σ11 grain boundary to the total length of all grain boundaries of 100% in the region A of the lower layer can be controlled by adjusting the presence or absence of the annealing step as well as each condition in the above steps 2 and 3 (formation step of region A). Specifically, for example, when the annealing step is conducted, the proportion of the sum of the length of the Σ3 grain boundary and the length of the Σ11 grain boundary to the total length of all grain boundaries of 100% in the region A of the lower layer can be reduced. For example, when the annealing step is conducted and the amount of TiCl₄ in the raw material in the steps 2 and 3 (formation step of region A) is increased, the proportion of the sum of the length of the Σ3 grain boundary and the length of the Σ11 grain boundary to the total length of all grain boundaries of 100% in the region A of the lower layer can be reduced. For example, when the annealing step is not conducted and the amount of TiCl₄ in the raw material in the steps 2 and 3 (formation step of region A) is increased, the proportion of the sum of the length of the Σ3 grain boundary and the length of the Σ11 grain boundary to the total length of all grain boundaries of 100% in the region A of the lower layer tends to be increased. For example, also when the proportion of the sum of the length of the Σ3 grain boundary and the length of the Σ11 grain boundary to the total length of all grain boundaries of 100% in the region B of the lower layer is increased, the proportion of the sum of the length of the Σ3 grain boundary and the length of the Σ11 grain boundary to the total length of all grain boundaries of 100% in the region A of the lower layer can be increased.

The proportion of the sum of the length of the Σ3 grain boundary and the length of the Σ11 grain boundary to the total length of all grain boundaries of 100% in the entire lower layer can be controlled by appropriately adjusting the proportion of the sum of the length of the Σ3 grain boundary and the length of the Σ11 grain boundary to the total length of all grain boundaries of 100% in each of the regions A and B in the lower layer.

Next, an upper layer made of an α-Al₂O₃ layer is formed on the surface of the lower layer. The upper layer is formed, for example, by the following method.

First, a lower layer composed of one or more Ti compound layers is formed on the surface of the substrate. Then, the surface of the layer farthest from the substrate is oxidized (hereinafter, this step is also referred to as "oxidation treatment step"). After that, an α-Al₂O₃ layer is formed on the surface of the layer subjected to the oxidation treatment (hereinafter, this step is also referred to as a "film forming step").

In the oxidation treatment step, the surface of the layer farthest from the substrate is oxidized under the conditions of the raw material composition of CO: 0.1 to 0.5 mol%, CO₂: 0.1 to 1.0 mol%, H₂: balance, the temperature of 950 to 1050°C, and the pressure of 45 to 65 hPa. The oxidation treatment time in this case is preferably 1 min to 5 min.

Then, in the film forming step, the α-Al₂O₃ layer is formed by a chemical vapor deposition method in which the raw material composition is AlCl₃: 2.0 to 4.0 mol%, CO₂: 1.0 to 5.0 mol%, HCl: 2.0 to 3.0 mol%, H₂S: 0.3 to 0.4 mol%, H₂: balance, the temperature is 950 to 1050°C, and the pressure is 60 to 80 hPa.

Next, an outer layer composed of a TiN layer and/or a TiCN layer is formed on the surface of the upper layer made of an α-Al₂O₃ layer. The outer layer is formed, for example, by the following method.

The TiN layer is formed by a chemical vapor deposition method in which the raw material composition is TiCl₄: 5.0 to 10.0 mol%, N₂: 20 to 60 mol%, H₂: balance, the temperature is 950 to 1050°C, and the pressure is 300 to 400 hPa.

The TiCN layer is formed by a chemical vapor deposition method in which the raw material composition is TiCl₄: 4.0 to 8.0 mol%, CH₃CN: 0.5 to 2.0 mol%, N₂: 3.0 to 7.0 mol%, H₂: balance, the temperature is 950 to 1050°C, and the pressure is 60 to 80 hPa.

The thickness of each layer in the coating layers of the coated cutting tool of the present embodiment can be measured by observing the sectional structure of the coated cutting tool using an optical microscope, a scanning electron microscope (SEM), an FE-SEM, or the like. In addition, the average thickness of each layer in the coated cutting tool of the present embodiment can be obtained by measuring the thickness of each layer at three or more locations in the vicinity of a position of 50 µm from the edge ridge portion toward the center of the rake face of the coated cutting tool and finding the arithmetic mean value thereof. Further, the composition of each layer can be measured from the sectional structure of the coated cutting tool of the present embodiment by using an energy dispersive X-ray spectrometer (EDS), a wavelength dispersive X-ray spectrometer (WDS), or the like.

### Examples

Hereinafter, the present invention will be described in more detail with reference to examples, but the present invention is not limited to these examples.

As a substrate, a cutting insert made of a cemented carbide having a composition of 93.7%WC-6.0%Co-0.3%Cr₃C₂ (the above numbers are mass%) and having an insert shape of CNMA120408 (ISO standard) was prepared. After round honing was performed on the edge ridge portion of the substrate with a SiC brush, the surface of the substrate was washed.

After washing the surface of the substrate, a coating layer was formed by a chemical vapor deposition method. First, the substrate was placed into an external heating type chemical vapor deposition apparatus, and under the conditions of the raw material composition, temperature and pressure shown in Table 1, the adhesion layer (TiN layer or TiC layer) having the composition shown in Table 5 was formed on the surface of the substrate to obtain the average thickness shown in Table 5. However, for Invention Sample 17, no adhesion layer was formed. Next, the lower layer side (region B) of the first layer of the lower layer having a composition shown in Table 5 was formed under the conditions of the raw material composition, temperature and pressure shown in Table 2 on the surface of the adhesion layer to have the average thickness that is 2.0 µm thinner than the average thickness of the entire lower layer shown in Table 5. Thereafter, the annealing step was conducted for the time shown in Table 2 under the conditions of the raw material composition, temperature and pressure shown in Table 1. However, for Comparative Samples 5 and 6, no annealing step was conducted. Subsequently, the upper layer side (region A) of the first layer of the lower layer having the composition shown in Table 5 was formed under the conditions of the raw material composition, temperature and pressure shown in Table 3 on the surface of the region B to have the average thickness shown in Table 5. However, for Invention Sample 24, the region A was formed of only the second layer of the lower layer. Next, the second layer (region A) of the lower layer having the composition shown in Table 5 was formed under the conditions of the raw material composition, temperature and pressure shown in Table 4 on the surface of the first layer of the lower layer to have the average thickness shown in Table 5. However, for Invention Sample 18, the region A was formed only of the upper layer side of the first layer of the lower layer, and no second layer of the lower layer was formed. As a result, the lower layer having the regions A and B was formed. Next, oxidation treatment was performed under the conditions of the raw material composition, temperature and pressure shown in Table 1. The oxidation treatment time was 3 min. Then, the upper layer (α-Al₂O₃ layer) having the composition shown in Table 5 was formed under the conditions of the raw material composition, temperature and pressure shown in Table 1 on the surface of the lower layer subjected to the oxidation treatment to obtain the average thickness shown in Table 5. Finally, the outer layer (TiN layer or TiCN layer) having the composition shown in Table 5 was formed under the conditions of the raw material composition, temperature and pressure shown in Table 1 on the surface of the upper layer (α-Al₂O₃ layer) to obtain the average thickness shown in Table 5. Thus, the coated cutting tools of Invention Samples 1 to 28 and Comparative Samples 1 to 12 were obtained.

The thickness of each layer of the sample was determined in the following manner. That is, using FE-SEM, the thickness at three points in the cross section in the vicinity of the position of 50 µm from the edge ridge portion of the coated cutting tool toward the center of the rake face was measured, and the arithmetic mean value was determined as the average thickness. The composition of each layer of the obtained sample was measured using EDS in the cross section near the position of 50 µm from the edge ridge portion of the coated cutting tool toward the center of the rake face.

**[Table 1]**

| | Composition | Temperature (°C) | Pressure (hPa) | Raw material composition (mol%) |
|---|---|---|---|---|
| Adhesion layer | TiN | 900 | 350 | TiCl₄:7.5%, N₂:40.0%, H₂:52.5% |
| | TiC | 1000 | 75 | TiCl₄:2.4%, CH₄:4.6%, H₂:93.0% |
| Annealing | | 1000 | 120 | C₂H₄:1.0%, N₂:45.0%,H₂:54.0% |
| Oxidation treatment | | 1000 | 55 | CO:0.3%, CO₂:0.5%,H₂:99.2% |
| Upper layer | α-Al₂O₃ | 1000 | 70 | AlCl₃:2.5%, CO₂:3.0%, HCl:2.3%, H₂S:0.35%, H₂:91.85% |
| Outer layer | TiN | 1000 | 350 | TiCl₄:7.5%, N₂:40.0%, H₂:52.5% |
| | TiCN | 1000 | 70 | TiCl₄:6.0%, CH₃CN:1.0%, N₂:5.0%, H₂:88.0% |

**[Table 2]**

| Sample Number | Lower layer-Lower layer side (First layer-Region B) | | | | | | | Annealing |
|---|---|---|---|---|---|---|---|---|
| | Temperature (°C) | Pressure (hPa) | Raw material composition (mol%) | | | | | Time (min) |
| | | | TiCl₄ | CH₃CN | C₂H₄ | N₂ | H₂ | |
| Invention Sample 1 | 840 | 75 | 7.5 | 1.0 | - | 15.0 | 76.5 | 30 |
| Invention Sample 2 | 860 | 75 | 7.5 | 1.2 | - | 15.0 | 76.3 | 15 |
| Invention Sample 3 | 840 | 75 | 7.5 | 0.8 | - | 15.0 | 76.7 | 45 |
| Invention Sample 4 | 860 | 55 | 7.5 | 1.2 | - | 15.0 | 76.3 | 45 |
| Invention Sample 5 | 880 | 110 | 7.0 | 0.8 | 0.5 | 25.0 | 66.7 | 15 |
| Invention Sample 6 | 840 | 75 | 7.0 | 1.0 | - | 10.0 | 82.0 | 40 |
| Invention Sample 7 | 840 | 75 | 7.0 | 1.2 | - | 10.0 | 81.8 | 40 |
| Invention Sample 8 | 820 | 70 | 8.0 | 1.2 | - | 25.0 | 65.8 | 30 |
| Invention Sample 9 | 820 | 70 | 8.0 | 1.2 | - | 30.0 | 60.8 | 30 |
| Invention Sample 10 | 820 | 75 | 7.0 | 1.0 | - | 15.0 | 77.0 | 30 |
| Invention Sample 11 | 840 | 75 | 7.0 | 1.0 | - | 15.0 | 77.0 | 30 |
| Invention Sample 12 | 860 | 75 | 7.5 | 1.0 | - | 15.0 | 76.5 | 30 |
| Invention Sample 13 | 820 | 75 | 7.5 | 0.8 | - | 15.0 | 76.7 | 30 |
| Invention Sample 14 | 840 | 75 | 7.5 | 1.0 | - | 15.0 | 76.5 | 30 |
| Invention Sample 15 | 880 | 75 | 7.5 | 1.0 | - | 15.0 | 76.5 | 30 |
| Invention Sample 16 | 820 | 75 | 7.5 | 0.8 | - | 15.0 | 76.7 | 30 |
| Invention Sample 17 | 880 | 75 | 8.0 | 1.2 | - | 15.0 | 75.8 | 30 |
| Invention Sample 18 | 840 | 75 | 8.0 | 1.0 | - | 15.0 | 76.0 | 30 |
| Invention Sample 19 | 860 | 75 | 8.0 | 1.0 | - | 15.0 | 76.0 | 30 |
| Invention Sample 20 | 840 | 75 | 7.5 | 0.8 | - | 15.0 | 76.7 | 30 |
| Invention Sample 21 | 840 | 75 | 8.0 | 1.2 | - | 15.0 | 75.8 | 30 |
| Invention Sample 22 | 860 | 75 | 7.5 | 1.0 | - | 15.0 | 76.5 | 20 |
| Invention Sample 23 | 840 | 75 | 7.0 | 1.0 | - | 15.0 | 77.0 | 45 |
| Invention Sample 24 | 840 | 85 | 7.0 | 0.8 | 0.2 | 15.0 | 77.0 | 15 |
| Invention Sample 25 | 880 | 100 | 6.0 | 1.2 | 0.4 | 35.0 | 57.4 | 15 |
| Invention Sample 26 | 840 | 75 | 7.5 | 1.0 | - | 15.0 | 76.5 | 30 |
| Invention Sample 27 | 860 | 75 | 7.5 | 0.8 | - | 15.0 | 76.7 | 30 |
| Invention Sample 28 | 840 | 75 | 7.5 | 1.0 | - | 15.0 | 76.5 | 30 |
| Comparative Sample 1 | 860 | 70 | 7.0 | 1.2 | - | 15.0 | 76.8 | 5 |
| Comparative Sample 2 | 840 | 70 | 7.0 | 0.8 | - | 15.0 | 77.2 | 5 |
| Comparative Sample 3 | 880 | 130 | 7.0 | 0.8 | 0.6 | 20.0 | 71.6 | 15 |
| Comparative Sample 4 | 860 | 130 | 7.0 | 1.0 | 0.6 | 15.0 | 76.4 | 15 |
| Comparative Sample 5 | 860 | 75 | 7.5 | 0.8 | - | 15.0 | 76.7 | - |
| Comparative Sample 6 | 840 | 75 | 7.5 | 1.0 | - | 15.0 | 76.5 | - |
| Comparative Sample 7 | 840 | 75 | 7.0 | 1.2 | - | 15.0 | 76.8 | 30 |
| Comparative Sample 8 | 840 | 75 | 7.0 | 1.2 | - | 15.0 | 76.8 | 30 |
| Comparative Sample 9 | 820 | 75 | 7.0 | 1.0 | - | 15.0 | 77.0 | 30 |
| Comparative Sample 10 | 840 | 80 | 7.0 | 1.2 | - | 10.0 | 81.8 | 20 |
| Comparative Sample 11 | 860 | 110 | 7.0 | 0.8 | 0.5 | 5.0 | 86.7 | 15 |
| Comparative Sample 12 | 840 | 75 | 7.0 | 1.0 | - | 15.0 | 77.0 | 15 |

| | | | | | | | | |
|---|---|---|---|---|---|---|---|---|
| * "-" in the column of Annealing indicates that the annealing step was not conducted. | | | | | | | | |

**[Table 3]**

| Sample Number | Lower layer-Upper layer side (First layer-Region A) | | | | | |
|---|---|---|---|---|---|---|
| | Temperature (°C) | Pressure (hPa) | Raw material composition (mol%) | | | |
| | | | TiCl₄ | CH₃CN | N₂ | H₂ |
| Invention Sample 1 | 1000 | 120 | 10.0 | 0.5 | 20.0 | 69.5 |
| Invention Sample 2 | 1020 | 120 | 9.0 | 0.5 | 20.0 | 70.5 |
| Invention Sample 3 | 980 | 120 | 11.0 | 0.5 | 20.0 | 68.5 |
| Invention Sample 4 | 1000 | 110 | 11.0 | 0.8 | 20.0 | 68.2 |
| Invention Sample 5 | 980 | 120 | 9.5 | 0.5 | 20.0 | 70.0 |
| Invention Sample 6 | 980 | 140 | 10.5 | 0.6 | 15.0 | 73.9 |
| Invention Sample 7 | 1000 | 130 | 10.0 | 0.4 | 15.0 | 74.6 |
| Invention Sample 8 | 1020 | 110 | 10.0 | 0.4 | 25.0 | 64.6 |
| Invention Sample 9 | 1000 | 100 | 10.0 | 0.5 | 25.0 | 64.5 |
| Invention Sample 10 | 1020 | 110 | 10.0 | 0.5 | 20.0 | 69.5 |
| Invention Sample 11 | 1000 | 120 | 10.0 | 0.6 | 20.0 | 69.4 |
| Invention Sample 12 | 980 | 130 | 10.0 | 0.7 | 20.0 | 69.3 |
| Invention Sample 13 | 980 | 120 | 10.0 | 0.5 | 20.0 | 69.5 |
| Invention Sample 14 | 1000 | 110 | 10.0 | 0.8 | 20.0 | 69.2 |
| Invention Sample 15 | 1000 | 110 | 10.0 | 0.4 | 20.0 | 69.6 |
| Invention Sample 16 | 1020 | 120 | 10.0 | 0.5 | 20.0 | 69.5 |
| Invention Sample 17 | 1000 | 130 | 10.0 | 0.5 | 20.0 | 69.5 |
| Invention Sample 18 | 1020 | 120 | 10.0 | 0.6 | 20.0 | 69.4 |
| Invention Sample 19 | 1000 | 120 | 10.0 | 0.8 | 20.0 | 69.2 |
| Invention Sample 20 | 980 | 110 | 10.0 | 0.7 | 20.0 | 69.3 |
| Invention Sample 21 | 1000 | 110 | 10.0 | 0.5 | 20.0 | 69.5 |
| Invention Sample 22 | 980 | 100 | 9.0 | 0.5 | 30.0 | 60.5 |
| Invention Sample 23 | 1000 | 130 | 11.0 | 0.5 | 10.0 | 78.5 |
| Invention Sample 24 | - | - | - | - | - | - |
| Invention Sample 25 | 1000 | 120 | 10.5 | 0.5 | 20.0 | 69.0 |
| Invention Sample 26 | 980 | 120 | 10.0 | 0.5 | 20.0 | 69.5 |
| Invention Sample 27 | 1020 | 120 | 10.0 | 0.6 | 20.0 | 69.4 |
| Invention Sample 28 | 1000 | 120 | 10.0 | 0.7 | 20.0 | 69.3 |
| Comparative Sample 1 | 1000 | 130 | 8.0 | 0.7 | 20.0 | 71.3 |
| Comparative Sample 2 | 980 | 140 | 8.0 | 0.7 | 0.0 | 91.3 |
| Comparative Sample 3 | 980 | 120 | 10.0 | 0.5 | 40.0 | 49.5 |
| Comparative Sample 4 | 1000 | 120 | 10.0 | 0.5 | 40.0 | 49.5 |
| Comparative Sample 5 | 1020 | 110 | 10.0 | 0.4 | 20.0 | 69.6 |
| Comparative Sample 6 | 1000 | 100 | 11.0 | 0.4 | 20.0 | 68.6 |
| Comparative Sample 7 | 980 | 120 | 10.0 | 0.6 | 20.0 | 69.4 |
| Comparative Sample 8 | 1000 | 120 | 10.0 | 0.7 | 20.0 | 69.3 |
| Comparative Sample 9 | 1000 | 120 | 10.0 | 0.6 | 20.0 | 69.4 |
| Comparative Sample 10 | 1020 | 130 | 9.0 | 0.6 | 10.0 | 80.4 |
| Comparative Sample 11 | 1020 | 130 | 10.5 | 0.8 | 35.0 | 53.7 |
| Comparative Sample 12 | 1020 | 110 | 10.0 | 0.6 | 20.0 | 69.4 |

| | | | | | | |
|---|---|---|---|---|---|---|
| * "-" indicates that the region A was formed only in the second layer. | | | | | | |

**[Table 4]**

| Sample Number | Lower layer-Region A (Second layer-Region A) | | | | | | |
|---|---|---|---|---|---|---|---|
| | Temperature (°C) | Pressure (hPa) | Raw material composition (mol%) | | | | |
| | | | TiCl₄ | CH₃CN | CO | N₂ | H₂ |
| Invention Sample 1 | 1000 | 120 | 10.0 | 0.5 | 1.5 | 20.0 | 68.0 |
| Invention Sample 2 | 1020 | 120 | 9.0 | 0.5 | 1.5 | 20.0 | 69.0 |
| Invention Sample 3 | 980 | 120 | 11.0 | 0.5 | 2.0 | 20.0 | 66.5 |
| Invention Sample 4 | 1000 | 110 | 11.0 | 0.8 | 2.0 | 20.0 | 66.2 |
| Invention Sample 5 | 980 | 120 | 9.5 | 0.5 | 1.5 | 20.0 | 68.5 |
| Invention Sample 6 | 980 | 140 | 10.5 | 0.6 | 2.0 | 15.0 | 71.9 |
| Invention Sample 7 | 1000 | 130 | 10.0 | 0.4 | 2.0 | 15.0 | 72.6 |
| Invention Sample 8 | 1020 | 110 | 10.0 | 0.4 | 1.0 | 25.0 | 63.6 |
| Invention Sample 9 | 1000 | 100 | 10.0 | 0.5 | 1.0 | 25.0 | 63.5 |
| Invention Sample 10 | 1020 | 110 | 10.0 | 0.5 | 1.5 | 20.0 | 68.0 |
| Invention Sample 11 | 1000 | 120 | 10.0 | 0.6 | 1.5 | 20.0 | 67.9 |
| Invention Sample 12 | 980 | 130 | 10.0 | 0.7 | 1.5 | 20.0 | 67.8 |
| Invention Sample 13 | 980 | 120 | 10.0 | 0.5 | 1.5 | 20.0 | 68.0 |
| Invention Sample 14 | 1000 | 110 | 10.0 | 0.8 | 1.0 | 20.0 | 68.2 |
| Invention Sample 15 | 1000 | 110 | 10.0 | 0.4 | 2.0 | 20.0 | 67.6 |
| Invention Sample 16 | 1020 | 120 | 10.0 | 0.5 | 1.5 | 20.0 | 68.0 |
| Invention Sample 17 | 1000 | 130 | 10.0 | 0.5 | 1.5 | 20.0 | 68.0 |
| Invention Sample 18 | - | - | - | - | - | - | - |
| Invention Sample 19 | 1000 | 100 | 6.0 | 0.0 | 2.5 | 0.0 | 91.5 |
| Invention Sample 20 | 980 | 110 | 10.0 | 0.7 | 1.0 | 20.0 | 68.3 |
| Invention Sample 21 | 1000 | 110 | 10.0 | 0.5 | 2.0 | 20.0 | 67.5 |
| Invention Sample 22 | 980 | 100 | 9.0 | 0.5 | 1.0 | 30.0 | 59.5 |
| Invention Sample 23 | 1000 | 120 | 11.0 | 0.5 | 2.0 | 10.0 | 76.5 |
| Invention Sample 24 | 1000 | 140 | 10.5 | 0.5 | 1.5 | 30.0 | 57.5 |
| Invention Sample 25 | 1000 | 120 | 10.5 | 0.5 | 1.5 | 10.0 | 77.5 |
| Invention Sample 26 | 980 | 120 | 10.0 | 0.5 | 1.5 | 20.0 | 68.0 |
| Invention Sample 27 | 1020 | 120 | 10.0 | 0.6 | 2.0 | 20.0 | 67.4 |
| Invention Sample 28 | 1000 | 120 | 10.0 | 0.7 | 1.0 | 20.0 | 68.3 |
| Comparative Sample 1 | 1000 | 130 | 8.0 | 0.7 | 1.5 | 20.0 | 69.8 |
| Comparative Sample 2 | 980 | 140 | 8.0 | 0.7 | 1.5 | 0.0 | 89.8 |
| Comparative Sample 3 | 980 | 120 | 10.0 | 0.5 | 1.5 | 40.0 | 48.0 |
| Comparative Sample 4 | 1000 | 120 | 10.0 | 0.5 | 1.5 | 40.0 | 48.0 |
| Comparative Sample 5 | 1020 | 110 | 10.0 | 0.4 | 2.0 | 20.0 | 67.6 |
| Comparative Sample 6 | 1000 | 100 | 11.0 | 0.4 | 1.0 | 20.0 | 67.6 |
| Comparative Sample 7 | 980 | 120 | 10.0 | 0.6 | 2.0 | 20.0 | 67.4 |
| Comparative Sample 8 | 1000 | 120 | 10.0 | 0.7 | 1.5 | 20.0 | 67.8 |
| Comparative Sample 9 | 1000 | 120 | 10.0 | 0.6 | 1.5 | 20.0 | 67.9 |
| Comparative Sample 10 | 1020 | 130 | 9.0 | 0.6 | 1.0 | 10.0 | 79.4 |
| Comparative Sample 11 | 1020 | 130 | 10.5 | 0.8 | 2.0 | 35.0 | 51.7 |
| Comparative Sample 12 | 1020 | 110 | 10.0 | 0.6 | 1.5 | 20.0 | 67.9 |

| | | | | | | | |
|---|---|---|---|---|---|---|---|
| * "-" indicates that the region A was formed only in the first layer. | | | | | | | |

**[Table 5]**

| Sample Number | Coating layer | | | | | | | | | | | | |
|---|---|---|---|---|---|---|---|---|---|---|---|---|---|
| | Adhesion layer | | Lower layer | | | | | Upper layer | | | Outer layer | | Average thickness of entire coating layer (µm) |
| | | | First layer | | Second layer | | Average thickness of entire lower layer (µm) | | | | | | |
| | Composition | Average thickness (µm) | Composition | Average thickness (µm) | Composition | Average thickness (µm) | | Composition | Crystal system | Average thickness (µm) | Composition | Average thickness (µm) | |
| Invention Sample 1 | TiN | 0.2 | TiCN | 7.0 | TiCNO | 1.0 | 8.0 | Al₂O₃ | α | 8.0 | TiN | 0.2 | 16.4 |
| Invention Sample 2 | TiN | 0.2 | TiCN | 7.0 | TiCNO | 1.0 | 8.0 | Al₂O₃ | α | 8.0 | TiN | 0.2 | 16.4 |
| Invention Sample 3 | TiN | 0.2 | TiCN | 7.0 | TiCNO | 1.0 | 8.0 | Al₂O₃ | α | 8.0 | TiN | 0.2 | 16.4 |
| Invention Sample 4 | TiN | 0.2 | TiCN | 7.0 | TiCNO | 1.0 | 8.0 | Al₂O₃ | α | 8.0 | TiN | 0.2 | 16.4 |
| Invention Sample 5 | TiN | 0.2 | TiCN | 7.0 | TiCNO | 1.0 | 8.0 | Al₂O₃ | α | 8.0 | TiN | 0.2 | 16.4 |
| Invention Sample 6 | TiN | 0.2 | TiCN | 3.0 | TiCNO | 1.0 | 4.0 | Al₂O₃ | α | 8.0 | TiN | 0.2 | 12.4 |
| Invention Sample 7 | TiN | 0.2 | TiCN | 7.0 | TiCNO | 1.0 | 8.0 | Al₂O₃ | α | 8.0 | TiN | 0.2 | 16.4 |
| Invention Sample 8 | TiN | 0.2 | TiCN | 7.0 | TiCNO | 1.0 | 8.0 | Al₂O₃ | α | 8.0 | TiN | 0.2 | 16.4 |
| Invention Sample 9 | TiN | 0.2 | TiCN | 11.0 | TiCNO | 1.0 | 12.0 | Al₂O₃ | α | 8.0 | TiN | 0.2 | 20.4 |
| Invention Sample 10 | TiN | 0.2 | TiCN | 3.0 | TiCNO | 1.0 | 4.0 | Al₂O₃ | α | 13.0 | TiN | 0.2 | 17.4 |
| Invention Sample 11 | TiN | 0.5 | TiCN | 13.0 | TiCNO | 1.0 | 14.0 | Al₂O₃ | α | 3.6 | TiN | 0.2 | 18.3 |
| Invention Sample 12 | TiN | 1.5 | TiCN | 12.0 | TiCNO | 1.0 | 13.0 | Al₂O₃ | α | 3.2 | TiN | 0.2 | 17.9 |
| Invention Sample 13 | TiN | 0.2 | TiCN | 3.5 | TiCNO | 1.0 | 4.5 | Al₂O₃ | α | 14.8 | TiN | 0.2 | 19.7 |
| Invention Sample 14 | TiN | 0.2 | TiCN | 5.0 | TiCNO | 1.0 | 6.0 | Al₂O₃ | α | 4.2 | TiN | 0.2 | 10.6 |
| Invention Sample 15 | TiN | 0.2 | TiCN | 13.5 | TiCNO | 1.0 | 14.5 | Al₂O₃ | α | 14.5 | TiN | 0.2 | 29.4 |
| Invention Sample 16 | TiC | 0.2 | TiCN | 7.0 | TiCNO | 1.0 | 8.0 | Al₂O₃ | α | 8.0 | TiN | 0.2 | 16.4 |
| Invention Sample 17 | - | - | TiCN | 7.0 | TiCNO | 1.0 | 8.0 | Al₂O₃ | α | 8.0 | TiN | 0.2 | 16.2 |
| Invention Sample 18 | TiN | 0.2 | TiCN | 7.0 | - | - | 7.0 | Al₂O₃ | α | 8.0 | TiN | 0.2 | 15.4 |
| Invention Sample 19 | TiN | 0.2 | TiCN | 7.0 | TiCO | 1.0 | 8.0 | Al₂O₃ | α | 8.0 | TiN | 0.2 | 16.4 |
| Invention Sample 20 | TiN | 0.2 | TiCN | 7.0 | TiCNO | 1.0 | 8.0 | Al₂O₃ | α | 8.0 | - | - | 16.2 |
| Invention Sample 21 | TiN | 0.2 | TiCN | 7.0 | TiCNO | 1.0 | 8.0 | Al₂O₃ | α | 8.0 | TiCN | 2.0 | 18.2 |
| Invention Sample 22 | TiN | 0.1 | TiCN | 7.0 | TiCNO | 1.0 | 8.0 | Al₂O₃ | α | 8.0 | TiN | 0.2 | 16.3 |
| Invention Sample 23 | TiN | 0.1 | TiCN | 7.0 | TiCNO | 0.5 | 7.5 | Al₂O₃ | α | 8.0 | TiN | 0.2 | 15.8 |
| Invention Sample 24 | TiN | 0.1 | TiCN | 7.0 | TiCNO | 20 | 9.0 | Al₂O₃ | α | 11.0 | TiN | 1.5 | 21.6 |
| Invention Sample 25 | TiN | 2.5 | TiCN | 7.0 | TiCNO | 1.0 | 8.0 | Al₂O₃ | α | 8.0 | TiN | 0.2 | 18.7 |
| Invention Sample 26 | TiN | 0.2 | TiCN | 5.8 | TiCNO | 1.0 | 6.8 | Al₂O₃ | α | 10.5 | TiN | 0.2 | 17.7 |
| Invention Sample 27 | TiN | 0.2 | TiCN | 9.0 | TiCNO | 1.0 | 10.0 | Al₂O₃ | α | 12.0 | TiN | 4.0 | 26.2 |
| Invention Sample 28 | TiN | 1.5 | TiCN | 5.0 | TiCNO | 1.0 | 6.0 | Al₂O₃ | α | 5.0 | TiN | 0.2 | 12.7 |
| Comparative Sample 1 | TiN | 0.2 | TiCN | 7.0 | TiCNO | 1.0 | 8.0 | Al₂O₃ | α | 8.0 | TiN | 0.2 | 16.4 |
| Comparative Sample 2 | TiN | 0.2 | TiCN | 7.0 | TiCNO | 1.0 | 8.0 | Al₂O₃ | α | 8.0 | TiN | 0.2 | 16.4 |
| Comparative Sample 3 | TiN | 0.2 | TiCN | 7.0 | TiCNO | 1.0 | 8.0 | Al₂O₃ | α | 8.0 | TiN | 0.2 | 16.4 |
| Comparative Sample 4 | TiN | 0.2 | TiCN | 7.0 | TiCNO | 1.0 | 8.0 | Al₂O₃ | α | 8.0 | TiN | 0.2 | 16.4 |
| Comparative Sample 5 | TiN | 0.2 | TiCN | 7.5 | TiCNO | 0.5 | 8.0 | Al₂O₃ | α | 8.0 | TiN | 0.2 | 16.4 |
| Comparative Sample 6 | TiN | 0.2 | TiCN | 7.0 | TiCNO | 1.0 | 8.0 | Al₂O₃ | α | 8.0 | TiN | 0.2 | 16.4 |
| Comparative Sample 7 | TiN | 0.2 | TiCN | 15.0 | TiCNO | 1.0 | 16.0 | Al₂O₃ | α | 3.5 | TiN | 0.2 | 19.9 |
| Comparative Sample 8 | TiN | 0.2 | TiCN | 12.0 | TiCNO | 1.0 | 13.0 | Al₂O₃ | α | 2.4 | TiN | 0.2 | 15.8 |
| Comparative Sample 9 | TiN | 0.2 | TiCN | 3.5 | TiCNO | 1.0 | 4.5 | Al₂O₃ | α | 16.0 | TiN | 0.2 | 20.9 |
| Comparative Sample 10 | TiN | 0.2 | TiCN | 7.0 | TiCNO | 1.0 | 8.0 | Al₂O₃ | α | 8.0 | TiN | 0.2 | 16.4 |
| Comparative Sample 11 | TiN | 0.2 | TiCN | 7.0 | TiCNO | 1.0 | 8.0 | Al₂O₃ | α | 8.0 | TiN | 0.2 | 16.4 |
| Comparative Sample 12 | TiN | 0.2 | TiCN | 15.0 | TiCNO | 1.0 | 16.0 | Al₂O₃ | α | 16.0 | TiN | 0.2 | 32.4 |

| | | | | | | | | | | | | | |
|---|---|---|---|---|---|---|---|---|---|---|---|---|---|
| * "-" indicates that the layer was not formed. | | | | | | | | | | | | | |

### Length of Grain Boundary

The proportion of the sum of the length of the Σ3 grain boundary and the length of the Σ11 grain boundary to the total length of all grain boundaries of 100% (hereinafter, also referred to as "(Σ3 + Σ11)/all grain boundaries") in the entire lower layer as well as the regions A and B in the obtained samples, and the proportion of the length of the Σ11 grain boundary to the sum of the length of the Σ3 grain boundary and the length of the Σ11 grain boundary (hereinafter, also referred to as "Σ11/(Σ3 + Σ11)") in the regions A and B of the lower layer were measured as follows. First, the coated cutting tool was polished in a direction perpendicular to the surface of the substrate until the cross-section of the lower layer is exposed to obtain an observation surface. The obtained observation surface was polished using colloidal silica to obtain a mirror polished surface of the observation surface.

Thereafter, the above observation surface was observed with an SEM equipped with EBSD. As the observation region, a rake face was observed.

As the SEM, SU6600 (manufactured by Hitachi High-Technologies Corporation) equipped with EBSD (manufactured by TexSEM Laboratories, Inc.) was used.

The normal to the observation surface was tilted by 70° with respect to an incident beam, and the analysis was carried out by irradiating the observation surface with an electron beam at an accelerating voltage of 15 kV and an irradiation current of 1.0 nA. Data collection was carried out by setting EBSD at a step size (distance between measurement points) of 0.1 µm in a measurement range including 50 µm in a direction parallel to the substrate surface and the entire lower layer in a direction perpendicular to the substrate surface on the observation surface and analyzing the crystal orientation of each grain in the lower layer in the measurement range. At this time, the boundary between measurement points having a misorientation of 5 degrees or more was taken as the grain boundary.

Data processing was carried out by using commercially available software. The CSL grain boundaries corresponding to any arbitrary Σn value were counted and confirmed by being expressed as the ratio to all grain boundaries. As described above, the length of the Σn grain boundary (n is an odd number of 3 or more and 29 or less) and the total length of all grain boundaries in the lower layer were determined. The analysis was performed at three fields of view in total in the above-described measurement range on the observation surface, and the average value of respective numerical values was determined. The proportion of the sum of the length of the Σ3 grain boundary and the length of the Σ11 grain boundary to the total length of all grain boundaries of 100% in the entire lower layer as well as the regions A and B, and the proportion of the length of the Σ11 grain boundary to the sum of the length of the Σ3 grain boundary and the length of the Σ11 grain boundary in the regions A and B of the lower layer were calculated from the obtained average values. The results are shown in Table 6.

**[Table 6]**

| Sample Number | Lower layer | | | | |
|---|---|---|---|---|---|
| | Region B | | Region A | | Entire lower layer |
| | Σ11/(Σ3+Σ11) (%) | (Σ3+Σ11)/All grain boundaries (%) | Σ11/(Σ3+Σ11) (%) | (Σ3+Σ11)/All grain boundaries (%) | (Σ3+Σ11)/All grain boundaries (%) |
| Invention Sample 1 | 3 | 38 | 38 | 25 | 35 |
| Invention Sample 2 | 3 | 40 | 22 | 26 | 37 |
| Invention Sample 3 | 3 | 39 | 59 | 23 | 35 |
| Invention Sample 4 | 1 | 40 | 39 | 24 | 36 |
| Invention Sample 5 | 19 | 36 | 37 | 23 | 33 |
| Invention Sample 6 | 2 | 22 | 46 | 12 | 17 |
| Invention Sample 7 | 3 | 24 | 45 | 15 | 23 |
| Invention Sample 8 | 3 | 61 | 36 | 54 | 59 |
| Invention Sample 9 | 4 | 68 | 35 | 57 | 66 |
| Invention Sample 10 | 3 | 36 | 37 | 26 | 31 |
| Invention Sample 11 | 3 | 37 | 39 | 25 | 35 |
| Invention Sample 12 | 3 | 38 | 40 | 24 | 36 |
| Invention Sample 13 | 3 | 38 | 38 | 25 | 32 |
| Invention Sample 14 | 2 | 37 | 39 | 26 | 33 |
| Invention Sample 15 | 4 | 37 | 37 | 26 | 35 |
| Invention Sample 16 | 3 | 38 | 38 | 24 | 35 |
| Invention Sample 17 | 2 | 41 | 37 | 23 | 37 |
| Invention Sample 18 | 3 | 42 | 40 | 25 | 37 |
| Invention Sample 19 | 3 | 41 | 24 | 17 | 35 |
| Invention Sample 20 | 3 | 38 | 39 | 25 | 35 |
| Invention Sample 21 | 3 | 42 | 38 | 26 | 38 |
| Invention Sample 22 | 3 | 38 | 28 | 48 | 41 |
| Invention Sample 23 | 3 | 37 | 53 | 18 | 32 |
| Invention Sample 24 | 12 | 28 | 44 | 20 | 26 |
| Invention Sample 25 | 17 | 55 | 38 | 24 | 47 |
| Invention Sample 26 | 3 | 39 | 37 | 25 | 35 |
| Invention Sample 27 | 4 | 38 | 38 | 24 | 35 |
| Invention Sample 28 | 2 | 40 | 39 | 26 | 35 |
| Comparative Sample 1 | 3 | 37 | 15 | 22 | 33 |
| Comparative Sample 2 | 4 | 36 | 17 | 7 | 29 |
| Comparative Sample 3 | 24 | 22 | 37 | 24 | 23 |
| Comparative Sample 4 | 23 | 16 | 38 | 25 | 18 |
| Comparative Sample 5 | 3 | 38 | 3 | 30 | 36 |
| Comparative Sample 6 | 2 | 55 | 1 | 38 | 51 |
| Comparative Sample 7 | 3 | 37 | 39 | 25 | 36 |
| Comparative Sample 8 | 2 | 35 | 38 | 25 | 33 |
| Comparative Sample 9 | 4 | 36 | 37 | 24 | 31 |
| Comparative Sample 10 | 3 | 20 | 18 | 6 | 17 |
| Comparative Sample 11 | 18 | 12 | 37 | 9 | 11 |
| Comparative Sample 12 | 3 | 36 | 25 | 24 | 35 |

Using the obtained Invention Samples 1 to 28 and Comparative Samples 1 to 12, cutting tests were conducted under the following conditions.

### Cutting Test 1

Work material: FCD600,
Work material shape: cylinder shape of 120 mm in diameter × 400 mm in length (four grooves at an equal distance on the outer peripheral surface of the cylinder),
Cutting speed: 120 m/min,
Feed: 0.30 mm/rev,
Depth of cut: 2.0 mm,
Coolant: water-soluble coolant,
Evaluation items: A time when a sample was fractured was defined as the end of the tool life, and the number of shocks to reach the end of the tool life was measured. The more excellent the fracture resistance is, the longer the tool life is.

Regarding the number of shocks to reach the end of the tool life in cutting test 1, 15000 shocks or more were evaluated as "A", 10000 shocks or more and less than 15000 shocks were evaluated as "B", and less than 10000 shocks were evaluated as "C". In this evaluation, "A" is the best, "B" is the second best, and "C" is the worst, and "A" or "B" means excellent cutting performance. Table 7 shows the obtained evaluation results.

### Cutting Test 2

Work material: FCD600,
Work material shape: disk shape of 180 mm in diameter × 23 mm in thickness (a hole of 70 mm in diameter at the center of the disk)
Cutting speed: 200 m/min,
Feed: 0.30 mm/rev,
Depth of cut: 2.0 mm,
Coolant: water-soluble coolant,
Evaluation item: A time when a sample was fractured or had a maximum flank wear width of 0.3 mm was defined as the end of the tool life, and the machining time to reach the end of the tool life was measured. The more excellent the wear resistance is, the longer the tool life is.

Regarding the machining time to reach the end of the tool life in cutting test 2, 32 min or more was evaluated as "A", 24 min or more and less than 32 min was evaluated as "B", and less than 24 min was evaluated as "C". In this evaluation, "A" is the best, "B" is the second best, and "C" is the worst, and "A" or "B" means excellent cutting performance. Table 7 shows the obtained evaluation results.

**[Table 7]**

| Sample Number | Cutting test 1 | | Cutting test 2 | |
|---|---|---|---|---|
| | Number of shocks (times) | Evaluation | Machining time (min) | Evaluation |
| Invention Sample 1 | 15000 | A | 33.0 | A |
| Invention Sample 2 | 13000 | B | 33.8 | A |
| Invention Sample 3 | 18500 | A | 35.2 | A |
| Invention Sample 4 | 15500 | A | 36.2 | A |
| Invention Sample 5 | 15000 | A | 30.8 | B |
| Invention Sample 6 | 13500 | B | 24.2 | B |
| Invention Sample 7 | 14500 | B | 28.6 | B |
| Invention Sample 8 | 13500 | B | 36.3 | A |
| Invention Sample 9 | 11000 | B | 37.9 | A |
| Invention Sample 10 | 12500 | B | 34.6 | A |
| Invention Sample 11 | 12500 | B | 28.2 | B |
| Invention Sample 12 | 13500 | B | 27.6 | B |
| Invention Sample 13 | 11500 | B | 35.2 | A |
| Invention Sample 14 | 17500 | A | 25.2 | B |
| Invention Sample 15 | 10500 | B | 35.9 | A |
| Invention Sample 16 | 14500 | B | 32.9 | A |
| Invention Sample 17 | 13500 | B | 30.8 | B |
| Invention Sample 18 | 13000 | B | 31.8 | B |
| Invention Sample 19 | 12000 | B | 30.1 | B |
| Invention Sample 20 | 15500 | A | 32.8 | A |
| Invention Sample 21 | 14500 | B | 33.7 | A |
| Invention Sample 22 | 12000 | B | 32.4 | A |
| Invention Sample 23 | 17500 | A | 34.2 | A |
| Invention Sample 24 | 16500 | A | 30.5 | B |
| Invention Sample 25 | 16000 | A | 35.2 | A |
| Invention Sample 26 | 14500 | B | 35.0 | A |
| Invention Sample 27 | 12000 | B | 36.3 | A |
| Invention Sample 28 | 17000 | A | 29.2 | B |
| Comparative Sample 1 | 6500 | C | 28.8 | B |
| Comparative Sample 2 | 5000 | C | 24.6 | B |
| Comparative Sample 3 | 9500 | C | 23.2 | C |
| Comparative Sample 4 | 8500 | C | 21.2 | C |
| Comparative Sample 5 | 4500 | C | 25.5 | B |
| Comparative Sample 6 | 5000 | C | 26.5 | B |
| Comparative Sample 7 | 7000 | C | 25.2 | B |
| Comparative Sample 8 | 12500 | B | 20.5 | C |
| Comparative Sample 9 | 8500 | C | 30.2 | B |
| Comparative Sample 10 | 4500 | C | 21.8 | C |
| Comparative Sample 11 | 7500 | C | 17.3 | C |
| Comparative Sample 12 | 4500 | C | 12.1 | C |

From the results shown in Table 7, the evaluations of the cutting tests 1 and 2 of Invention Samples were "B" or higher. Meanwhile, the evaluation of the Comparative Samples was "C" in either or both of the cutting tests 1 and 2. Therefore, it can be seen that the wear resistance and fracture resistance of the Invention Samples are generally superior to those of the Comparative Samples. From the above results, it was found that the Invention Samples have a long tool life as a result of being excellent in wear resistance and fracture resistance.

### Industrial Applicability

Since the coated cutting tool of the present invention has excellent wear resistance and fracture resistance, the tool life can be extended as compared with the conventional coated cutting tool, and from such a viewpoint, the coated cutting tool of the present invention has industrial applicability.

### Reference Signs List

1: Substrate, 2: Adhesion layer, 3: Lower layer, 4: Upper layer, 5: Outer layer, 6: Coating layer, 7: Coated cutting tool, 3a: Region A, 3b: Region B

## Claims

1. A coated cutting tool comprising a substrate and a coating layer formed on a surface of the substrate, wherein
the coating layer comprises a lower layer and an upper layer formed on a surface of the lower layer,
the lower layer comprises a Ti compound layer containing a Ti compound of Ti and at least two elements selected from the group consisting of C, N, O and B,
an average thickness of the lower layer is 3.0 µm or more and 15.0 µm or less,
the upper layer comprises an α-Al₂O₃ layer containing α-aluminum oxide,
an average thickness of the upper layer is 3.0 µm or more and 15.0 µm or less,
a proportion of a sum of a length of a Σ3 grain boundary and a length of a Σ11 grain boundary to a total length of all grain boundaries of 100% is 15% or more in the entire lower layer, and
when a range of 2 µm from an interface between the lower layer and the upper layer to the substrate side is taken as a region A and a range on the substrate side of the region A is taken as a region B, a proportion of the length of the Σ11 grain boundary to the sum of the length of the Σ3 grain boundary and the length of the Σ11 grain boundary is 20% or more in the region A of the lower layer, and the proportion of the length of the Σ11 grain boundary to the sum of the length of the Σ3 grain boundary and the length of the Σ11 grain boundary is 0% or more and less than 20% in the region B of the lower layer.

2. The coated cutting tool according to claim 1, wherein the proportion of the sum of the length of the Σ3 grain boundary and the length of the Σ11 grain boundary to the total length of all grain boundaries of 100% is 10% or more and 60% or less in the region A of the lower layer.

3. The coated cutting tool according to claim 1 or 2, wherein the proportion of the sum of the length of the Σ3 grain boundary and the length of the Σ11 grain boundary to the total length of all grain boundaries of 100% is 20% or more and 70% or less in the region B of the lower layer.

4. The coated cutting tool according to any one of claims 1 to 3, wherein the coating layer comprises an adhesion layer between the lower layer and the substrate,
the adhesion layer comprises a Ti nitride layer and/or a Ti carbide layer, and
an average thickness of the adhesion layer is 0.1 µm or more and 3.0 µm or less.

5. The coated cutting tool according to any one of claims 1 to 4, wherein the coating layer further comprises an outer layer on a surface of the upper layer opposite to the substrate,
the outer layer comprises a compound of Ti and at least one element selected from the group consisting of C, N, O and B, and
an average thickness of the outer layer is 0.1 µm or more and 4.0 µm or less.

6. The coated cutting tool according to any one of claims 1 to 5, wherein an average thickness of the entire coating layer is 10.0 µm or more and 30.0 µm or less.

7. The coated cutting tool according to any one of claims 1 to 6, wherein the substrate is composed of any of a cemented carbide, a cermet, a ceramic and a cubic boron nitride sintered body.
